Europäisches Patentamt

European Patent Office    (11) Publication number: **0 026 211**

Office européen des brevets                              **B1**

(19)

(12) **EUROPEAN PATENT SPECIFICATION**

(45) Date of publication of patent specification: **16.05.84**    (51) Int. Cl.³: **H 05 K 3/10, G 03 G 9/00**

(21) Application number: **80900719.8**

(22) Date of filing: **11.04.80**

(86) International application number:
**PCT/DK80/00023**

(87) International publication number:
**WO 80/02222 16.10.80 Gazette 80/23**

(54) **A METHOD FOR DRY SENSITIZATION OF AN INSULATING SURFACE.**

(30) Priority: **11.04.79 DK 1507/79**

(43) Date of publication of application:
**08.04.81 Bulletin 81/14**

(45) Publication of the grant of the patent:
**16.05.84 Bulletin 84/20**

(84) Designated Contracting States:
**CH DE FR GB LI NL SE**

(56) References cited:
**CH-A- 581 851**
**DE-A-2 159 467**
**DE-A-2 324 378**
**DE-A-2 606 998**
**DE-A-2 815 696**
**DE-B-2 249 384**
**DE-B-2 603 005**
**FR-A-2 221 533**
**GB-A- 299 903**
**GB-A- 567 503**
**GB-A-1 159 542**
**GB-A-1 175 832**
**GB-A-1 251 285**

(73) Proprietor: **A/S NESELCO**
**Haydnsvej 2**
**DK-2450 Copenhagen SV (DK)**

(72) Inventor: **SORENSEN, Gunnar**
**Fortevej 86B**
**DK-8240 Risskov (DK)**
Inventor: **SVENDSEN, Leo Gulvad**
**de Mezasvej 13, 4.th.**
**DK-8000 Aarhus C (DK)**

(74) Representative: **Vossius Vossius Tauchner**
**Heunemann Rauh**
**Siebertstrasse 4 P.O. Box 86 07 67**
**D-8000 München 86 (DE)**

(56) References cited:
**GB-A-1 348 910**
**GB-A-1 431 699**
**SE-B- 303 074**
**SE-B- 337 152**
**SE-B- 363 854**
**US-A-2 910 351**
**US-A-2 947 625**
**US-A-2 966 429**

US-A-3 785 983
US-A-3 826 747
US-A-3 880 689
US-A-4 042 730
US-A-4 134 847

Xerography and Related Processes John H
Dessauer, Harold E Clark, London see page
463-464

## Description

The invention relates to a process for selective sensitization of the surface of an insulating substrate with a view to a subsequent treatment with an activator followed by electroless deposition of a metal thereon. In the process of the invention the sensitized pattern on the insulating substrate is prepared by a dry, xerographic step.

Within electronics, it has for a long time been desirable to be able to transfer conducting materials in a prescribed pattern (selectively) with good adherence to the surface of an insulating substrate. The prescribed pattern mentioned might have details that do not touch other parts of the pattern. Therefore, electroless deposition of the metal has been used for producing the pattern.

There are basically two possibilities of preparing the substrate for electroless deposition of a metal:

— those parts of the surface which should not be metallized can be masked and/or
— those parts which should be metallized can be sensitized.

There is known in the field of the art a process for providing a conducting material on an insulating substrate comprising three essential steps (preconditioning and rinsing not included); see e.g. US—A 4,042,730. The first two steps of this process are commonly called "sensitization" and "activation". The third step is the electroless deposition of the conducting material. These process steps are generally carried out in aqueous solutions.

In the sensitization step a reducing metal compound e.g. a tin (II) compound is applied to the surface of the insulating substrate by immersing said substrate into a solution containing the reducing compound. This compound "sensitizes" the surface for the subsequent application of an "activator".

The activation step comprises applying a compound of a noble metal (usually $PdCl_2$) to the sensitized surface of the insulating substrate. When the sensitized substrate is immersed into a solution containing the activator compound, said compound is reduced to its metallic state and precipitated on the sensitized parts of the substrate providing the "activator" or "catalyst" for subsequent electroless plating. The precipitation of the activator is a chemical redox process in which the sensitizer ($Sn^{2+}$) is oxidized (to $Sn^{4+}$) and the activator compound ($Pd^{2+}$) is reduced to give the activator metal ($Pd^0$). The sensitizer acts to enhance the adherence of the activator to the substrate.

There are however two main problems in the sensitization step of the three step process as explained above. The first is that it is difficult to get a selective sensitization of the surface. The second problem is that the adherence of the reducing agent to the substrate applied in the wet process is not very good.

A different approach for obtaining a pattern is selective desensitization by ultraviolet light, as described in the proceedings of the conference Physics in Industry 1976: "New Photoimaging Processes for Industrial Use—a Link between Basic and Applied Research", pp. 101—105.

In order to improve the adherence the separate sensitization and activation processes have been combined into one process as described in US—A 3,969,554. The use of a single bath sensitizer/activator solution has been described in some detail in Rantell and Holtz in Electroplating and Metal Finishing, Vol. 27, No. 2, 1974, pp 15—20.

Recently pure organic solutions for sensitization have been described, e.g. in DK—B— 132 801. In this patent the function of these solutions and the advantages and disadvantages of aqueous and organic solvents have been outlined comprehensively. The method, where an organic solvent is used, is based upon direct deposition of, e.g., Pd to the surface of the substrate by evaporating the organic solvent, which might also have etched the surface of the substrate.

In a further "additive" process for the production of printed circuits socalled catalytic lacquers are used which according to DE—A 2 635 457 contain a binder, water, a metal salt, a complexing agent and a reducing agent. The catalytic lacquer may be applied to a substrate, e.g. by serigraphie.

The terminology which is commonly used in this field of the art has been explained in detail above in order to give a clear description of the distinct process steps carried out during the preparation of the insulating substrate for electroless metal deposition. In any case it should be avoided to mix up the terms "sensitization" and "activation". It has to be admitted, however, that unfortunately this terminology is not used in the entire literature in the same meaning as outlined above. This will be explained in more detail below in connection with the acknowledgement of the prior art known from US—A 3,880,689.

The above described "wet" processes have as already mentioned the disadvantage that the precision of the metallization is low as it is determined by the method used for the production of the sensitized pattern. As an example can be mentioned serigraphy, where the resolution will not be better than the mesh gauge of the silk screen. Also confluency and diffluency before drying may occur.

Another problem in connection with the known sensitization and activation processes is that the adherence of the deposited material is not satisfactory, a problem which is well-known from non-selective metallizing. Further proposals for solutions of these problems are, for example, described in SE—A—350 774 (rubbing-in together with slight grinding), GB—A—1 324 653 (ion bombardment) and DE—B—1 571 802 (deposition of a binding layer prior to atomization of metal particles).

A "subtractive" method for producing a conducting pattern on the surface of a substrate consists in electrostatic precipitation of a masking layer, which is a positive picture of the desired conductive pattern on an existing layer of Cu on the insulating substrate. According to US—A—2,966,429 and 2,910,351, the layer is produced by fusing of an electrostatically transferred thin layer of a dielectric powder. After removal of the non-masked Cu layer followed by removal of the mask, the conducting pattern will be left.

This known process is time-consuming, but provides good results when coarse details such as printed circuits with satisfactory adherence are produced. However, stationary "pattern electrodes" are used for the transfer of the pattern which makes it difficult to alter the conductive pattern. Actually, the transfer only consists in selectively protecting parts of a laminated layer of Cu against being etched away, hence the good adherence may be ascribed to the lamination process.

In US—A—3,880,689 a method is described which aims at strengthening the contrast and density of a conventionally developed magnetic image by electroless plating of a metal on the image parts. For this purpose a toner developer is used which contains a compound (called in said patent "sensitizer") which permits the visible image to be electrolessly plated. It is stated that the developed image may be transferred to a current board and a printed circuit board is formed by electroless plating onto the transferred image.

As "sensitizers" there are mentioned in US—A—3,880,689 the metals of the groups IB and VIII of the periodic table and tin. Palladium, platinum, gold and silver are preferred, palladium being most preferred. The "sensitizers" are deposited on the substrate in the form of a compound thereof, together with the toner powder. Upon treatment with the electroless plating solution the "sensitizer" is reduced to give the catalyst for electroless plating. This reduction is effected by a reducing agent contained in the plating solution, e.g. formaldehyde or a $NaH_2PO_2$ solution. The reduced metallic "sensitizer", preferably palladium, provides the desired bonding sites for the metal to be deposited on the visible image.

The above description of the mechanism of the "sensitization" according to US—A—3,880,689 makes it clear that the metals designated as "sensitizers" are in fact "activators" according to the common terminology as explained above. They are applied to the substrate in the form of compounds which are reduced to the metal in the plating step by a reducing agent contained in the plating solution.

The same mechanism applies to the case described in US—A—3,880,689, where tin (tin dibromide) is said to be used as "sensitizer". Provided that tin really reacts in the described manner, which is doubtful, according to the mechanism described in US—A—3,880,689 the $Sn^{2+}$ compound will be reduced by a reducing agent contained in the plating solution. Tin in its metal state would be precipitated on the substrate providing the bonding sites for the metal to be deposited electrolessly. However, tin (II) salts are known to be strong reducing agents. Therefore it seems to be doubtful whether a tin (II) salt will be reduced to metallic tin in an ordinary plating solution.

The magnetic imaging process described in US—A—3,880,689 is not satisfactory for the production of electrolessly plated patterns on insulating substrates, especially printed circuits, for the reasons stated in the following. The adherence of the deposited metal to the substrate is not good because there is no oxidized sensitizer (according to the usual terminology=a tin (IV)-compound) present between the substrate and the noble metal (Pd) which secures good bonding. Furthermore, the process of electroless deposition of a metal is extremely slow. The toner containing the "sensitizer" (according to the terminology used in US—A 3,880,689=$Pd^{2+}$) is prepared in an organic solvent. Only a little "sensitizing" compound is present on the surface of the toner and this has first to be reduced before the electroless deposition of the metal can start at the catalytic sites so created. Therefore this process is not appropriate for applying thick layers of pure metal as are necessary for printed circuits, because a long time would be necessary during which the alkaline agent present in the plating solution according to this known process would attack the polymer substrate, and the deposited copper would be converted to CuO.

Finally, toners containing a coloring agent and a chelate compound of EDTA with a metal are known from DE—A 23 24 378. The said metal may be i.e. tin. These known toners can be charged positively and are used for the development of electric images in electrophotography.

It is the object of the present invention to provide a process for selective sensitization of the surface of an insulating substrate with a view to a subsequent treatment with an activator followed by electroless deposition of a metal thereon, which process can be carried out rapidly and results in good adherence of the deposited metal to the substrate, good resolution of the pattern and which permits to alter the pattern easily.

This object is achieved by the process according to the invention in which a dry, xerographic method is used for sensitizing the insulating substrate. This process comprises forming a latent image of the desired pattern by xerography, developing the latent image with the toner powder which contains a sensitizer (according to the usual terminology of the three-step process) and transferring the developed image to the surface of the insulating substrate, a sensitized substrate being obtained thereby which can be treated with the activating solution and then with the plating solution.

The subject matter of the invention is therefore a process for selective sensitization of the surface of an insulating substrate with a view to a subsequent treatment with an activator followed by electroless deposition of a metal thereon, which is characterized in that the sensitization is carried out as a dry process whereby a latent image of the metal pattern to be deposited by electroless plating is formed by a xerographic process, the latent image is developed using a toner powder containing a metal compound which is a sensitizer for the activator used for electroless plating, the developed image is transferred to the surface of the insulating substrate and treated to secure its appearance thereto.

According to the present invention the dry sensitization process using a xerographic method replaces the wet sensitization process of the known three-step process for producing conductive patterns on insulating substrates. The dry sensitization method of the invention, in which a latent image produced by xerography is developed with a toner powder containing the sensitizer and then transferred to the substrate, brings about several unexpected advantages over the prior art.

The use of xerography permits to prepare very easily any desired pattern by a simple imaging process which can be carried out in any common xerographic apparatus. Fine patterns and high resolution can easily be achieved.

The use of the sensitizer according to the known three-step process results in a good adhesion of the noble metal (activator or catalyst) and of the electrolessly deposited metal onto the substrate. Such an adhesion cannot be achieved when the activator is directly applied to the substrate. The adhesion of the sensitizer itself to the substrate can easily be achieved for example by "burning down" the toner powder as will be explained below.

A further advantage is that the overall process for electroless metal deposition can be carried out very rapidly. The xerographic sensitizing step itself is very fast. It also provides some surface roughness which favours speed of plating and adhesion. Then the substrate is immersed into the activator solution where metallic activator (Pd$^0$) is rapidly deposited on the sensitized parts of the surface by an ionic redox process. After rinsing, the substrate with the activator already present in its active state is immersed into the metallizing bath, where electroless metal deposition immediately starts.

The process of the invention is very favorable under environmental aspects because no pre-etching of the substrate is required and the waste problems especially of the subtractive processes are entirely avoided. Further a very low palladium consumption makes the process very economic.

The dry sensitization of an insulating substrate using a xerographic process according to the invention is suggested for the first time in the present invention. The process described in US—A 3,880,689 refers to magnetic printing, i.e. a different technology. A simple transfer of the process from magnetic printing to an electrophotographic imaging process does not result in the process of the invention, but in a process in which the xerographic image would be developed with a toner powder containing the activator compound (noble metal compound; e.g. PdCl$_2$). A rapid deposition of the subsequently deposited metal and good adherence thereof could not be achieved in this way.

The toner powder to be used in the process according to the invention usually comprises a thermoplastic material. The sensitizer, e.g. a Sn$^{2+}$ compound can be precipitated on the surface of each powder particle. In another embodiment the Sn$^{2+}$ compound may be distributed in each powder particle.

The toner powder to be used in the process according to the invention may have the property that, when present in a molten state, it wets the surface to be sensitized.

After the transfer of the latent image the substrate and the toner powder may be treated with an organic solvent to obtain adherence. In another embodiment adherence between the toner powder and the substrate surface may also be achieved by at least local melting of the substrate surface.

The toner powder may also contain an infrared-absorbing material or the main constituent of the toner powder may be a material with a large loss angle at microwave frequencies.

The invention will be further described in the following with reference to preferred embodiments and examples of preparations which have proved to be particularly advantageous in connection with the reduction of the invention to practice.

What makes it possible to utilize a procedure as specified in the present invention, and which has not been known hitherto, is that it still may be advantageous to use a three-step process as that described in the introduction, but that it is possible to avoid the wet process at the transfer of the Sn$^{+2}$ compound, the sensitizing part of the process, and the subsequent selective desensitizing. The adherence between the Sn$^{+2}$ compound and the surface of the substrate in the wet process is not overwhelmingly good, but quite surprisingly it has appeared that the transfer performed according to the invention gives an adherence, which is extremely good, i.e., that the Pd and Cu atoms deposited in the following process steps have a better fixation to the substrate than it has been possible to obtain so far.

The xerographic process has appeared to be well-suited for transfer of the sensitizing $Sn^{+2}$ compound as it provides both a suitable coverage of the insulating substrate and a suitable resolution, which are normally conflicting aims. Furthermore, many of the polymer resins used for toning powders in xerographic copying machines are well suited as regards adhesion to a large number of different substrate materials. As an example, reference is made to those mentioned in US Patent 2 966 429; furthermore, it will be a simple matter for the man skilled in the art to check the usability of commercially available polymer resins. Good results are obtained with such different materials as polyacrylates, polyamides, polyvinylchlorides, and phenol resin. As usable substrate materials may be mentioned polyesters, polyacrylates, polyvinylchlorides, polycarbonates, i.e., a great deal of the materials used in practical electronics.

The fixation to the surface of the insulating substrate can partly be obtained by methods, which are well known for powders not containing sensitizing metal compounds, usually by "burning down". This means that each particle of the powder is heated so that when melting, it spreads on the surface to an extent which depends on the degree to which the surface is wetted by the molten powder (the surface tension). According to the invention, the same demands are not made to a pore-free confluencing as are made in the procedures that are based on using the layer obtained as a mask prior to etching. This is probably connected with the sensitizing mechanism which, rather than demanding an even surface as a basis for the subsequent electroless metal deposition, uses the metal-compound particles deposited on the surface as a seed. This means that the demands on adherence are greater than the demands on spreading.

With a view to obtaining a local heating of the transferred particles, materials have been added to them which absorb the energy radiation, the wavelength of which depends on the application and combination of substrate/powder. In cases where the powder material is not thermoplastic, it will be expedient to let each powder particle heat the surface of the substrate in this area of contact, and a suitable choice of softening temperature for the substrate will make a melting-down possible in this case. This method is just a special case of the method that consists in heating all of the surface to the melting point.

In circumstances where heating is not desirable, fixation can be made by letting the powder on the substrate pass an atmosphere with a suitable vapour pressure of an organic solvent which, in the well-known way, makes the substrate and particles stick to one another, and subsequently evaporate the solvent.

There are several ways of producing the powders used according to the invention. The methods used so far have all had the purpose of securing that each powder particle, at least on its surface, has had a reasonably even distribution of $Sn^{+2}$ compounds. This can be obtained in two principally different ways: either directly by impregnating the surface of each particle, or by producing a solid mass aiming at an even distribution of the sensitizing compound in the plastic material which is subsequently pulverized in the usual way to obtain a suitable size of the particles. This size is determined by the construction of the xerographic transfer apparatus and is a well-known technique in the field in question.

Example 1

Production of a sensitizing powder, aiming at an even distribution of tin compounds in the material:

To 10 g of a plastic material 0.05—0.5 g of $SnCl_2 \cdot 2H_2O$ are added. This mixture can be wet- or dry-ground in an aqueous or organic liquid. Then the liquid may be removed by a conventional drying technique, e.g. evaporation, filtration, or spray-drying.

In the impregnation of the individual plastic particles with a tin compound, according to the invention, as starting material an already existing powder may be used. According to another embodiment impregnation may also be carried out during the production of the plastic powder. The more appropriate way of obtaining the desired distribution of tin in the individual plastic particle is during the production of the powder. This can, for example, be achieved by atomizer-drying (spray-drying) of the plastic-containing solution, which also contains a tin compound.

As certain $Sn^{+2}$ compounds, e.g. $SnCl_2 \cdot 2H_2O$ are soluble in organic solvents, it is possible to influence the powder individually by a solvent, which makes the particles swell and hence absorb the tin compounds which are dissolved in the organic solvent. Evaporation of the solvent creates the desired distribution of $SnCl_2 \cdot 2H_2O$.

Example 2

A plastic powder, which swells when an organic solvent is used, is suspended in such a solvent, to which is added a saturated solution of $SnCl_2 \cdot 2H_2O$ in methanol without precipitation of tin compounds. After a certain time of reaction, the solvent can be removed by e.g. filtering or spray-drying of the suspension, which now contains the prepared powder. The quantity of tin to be added depends to a great extent on the combination of plastic material and solvent and their relative volumes and also on the method of drying the powder. In so far as the plastic material can be completely dissolved in an organic solvent, a tin compound, also in an organic solvent, may be added. Then the powder can be obtained by a conventional process of drying, e.g. by spray-drying of the plastic-containing solution.

Another method, which has been successfully used, is a chemical precipitation of an $Sn^{+2}$ compound on the powder particles during continuous stirring.

## Example 3

Precipitation of a tin compound on each plastic particle. 10 g plastic powder is suspended in 200 ml methanol. While stirring, a saturated solution of $SnCl_2 \cdot 2H_2O$ in methanol is added, the quantity depending on the size of the powder particles. The weight of the $SnCl_2 \cdot 2H_2O$ may be e.g. 1—10% of that of the plastic powder. While stirring, an alkaline agent is added, causing the suspended plastic powder to act as a scavenger for the precipitation of hydroxy-tin-chlorides. The powder prepared in this way can then be dried, and if necessary, ground and sieved.

Through the development of the method according to the invention, sensitization of an insulating surface has been obtained with a view to a subsequent electroless metallization, performed by known methods, without demanding preceding special masters or masks, as any pattern which can be copied by a xerographic process, can be transferred to the desired substrate surface. The method does not put heavy demands on resources nor is it detrimental to environment, as an etching-off of the superfluous metal layer is avoided. Furthermore, the metal layer transferred by electroless metallization has a much better adherence to the surface of the substrate (e.g. as measured by the Scotch-Tape method) than layers of the same thickness, which have been transferred by conventional electroless deposition or by evaporation or vapour-phase deposition methods. In addition, the present method makes much less demands on the cleaning of the surface of the substrate prior to metallization than do the methods mentioned above.

## Claims

1. Process for selective sensitization of the surface of an insulating substrate with a view to a subsequent treatment with an activator followed by electroless deposition of a metal thereon, characterized in that the sensitization is carried out as a dry process whereby a latent image of the metal pattern to be deposited by electroless plating is formed by a xerographic process, the latent image is developed using a toner powder containing a metal compound which is a sensitizer for the activator used for electroless plating, the developed image is transferred to the surface of the insulating substrate and treated to secure its adherence thereto.

2. Process according to claim 1, characterized in that the toner powder is a thermoplastic material which contains an $Sn^{+2}$ compound precipitated on the surface of each powder particle.

3. Process according to claim 1, characterized in that the toner powder is a thermoplastic material which contains an $Sn^{+2}$ compound distributed in each powder particle.

4. Process according to claim 2 or 3, characterized in that the surface to be sensitized by the molten plastic material is wetted.

5. Process according to claim 1, characterized in that the adhesion between the toner powder and the surface of the substrate is achieved by the use of an organic solvent.

6. Process according to claim 1, characterized in that the adherence between the surface of the substrate and the powder particles is achieved by at least local melting.

7. Process according to claims 1 or 6, characterized in that the powder particles contain an infrared-absorbing material.

8. Process according to claims 1 or 6, characterized in that the main constituent of the toner powder is a material with a large loss angle at microwave frequencies.

## Patentansprüche

1. Verfahren zur selektiven Sensibilisierung der Oberfläche eines isolierenden Substrates im Hinblick auf eine folgende Behandlung mit einem Aktivator gefolgt von stromloser Abscheidung eines Metalls darauf, dadurch gekennzeichnet, daß die Sensibilisierung als trockenes Verfahren ausgeführt wird, wobei durch einen xerographischen Prozeß ein latentes Bild des durch stromlose Plattierung abzuscheidenden Metallmusters erzeugt wird, das latente Bild unter Verwendung eines Tonerpulvers entwickelt wird, das eine Metallverbindung enthält, welche ein Sensibilisator für den zur stromlosen Plattierung verwendeten Aktivator ist, das entwickelte Bild auf die Oberfläche des isolierenden Substrates übertragen und zur Sicherstellung seiner Haftung darauf behandelt wird.

2. Verfahren nach Anspruch 1, dadurch gekennzeichnet, daß das Tonerpulver ein thermoplastisches Material ist, das eine auf der Oberfläche eines jeden Pulverteilchens abgeschiedene $Sn^{+2}$-Verbindung enthält.

3. Verfahren nach Anspruch 1, dadurch gekennzeichnet, daß das Tonerpulver ein thermoplastisches Material ist, das eine in jedem Pulverteilchen verteilte $Sn^{+2}$-Verbindung enthält.

4. Verfahren nach Anspruch 2 oder 3, dadurch gekennzeichnet, daß die zu sensibilisierende Oberfläche durch das geschmolzene Kunststoffmaterial benetzt wird.

5. Verfahren nach Anspruch 1, dadurch gekennzeichnet, daß die Haftung zwischen dem Tonerpulver und der Oberfläche des Substrates durch Verwendung eines organischen Lösungsmittels erreicht wird.

6. Verfahren nach Anspruch 1, dadurch gekennzeichnet, daß die Haftung zwischen der Oberfläche des Substrates und den Pulverteilchen durch mindestens lokales Schmelzen erreicht wird.

7. Verfahren nach Anspruch 1 oder 6, dadurch gekennzeichnet, daß die Pulverteilchen ein IR-absorbierendes Material enthalten.

8. Verfahren nach Anspruch 1 oder 6, dadurch gekennzeichnet, daß der Hauptbestandteil des Tonerpulvers ein Material mit einem großen Verlustwinkel bei Mikrowellenfrequenzen ist.

**Revendications**

1. Procédé de sensibilisation sélective de la surface d'un substrat isolant en vue d'un traitement ultérieur par un agent d'activation suivi d'un dépôt non électrolytique d'un métal, et caractérisé par le fait que la sensibilisation est effectuée par un procédé à sec, à savoir que l'on forme, par xérographie, une image latente du motif en matériau métallique qui doit être déposé par revêtement anélectrolytique; l'image latente est développée à l'aide d'un révélateur en poudre (le toner) contenant un composé métallique qui sert de sensibilisateur pour l'agent d'activation utilisé lors du revêtement anélectrolytique; puis l'image développée est transposée sur la surface du substrat isolant et traitée afin de garantir son adhérence sur celui-ci.

2. Procédé conforme à la revendication 1, caractérisé par le fait que le révélateur en poudre (toner) est un matériau thermoplastique qui contient un composé $Sn^{+2}$ précipité à la surface de chaque grain de poudre.

3. Procédé conforme à la revendication 1, caractérisé par le fait que le révélateur en poudre (toner) est un matériau thermoplastique qui contient un composé $Sn^{+2}$ réparti dans chaque grain de poudre.

4. Procédé conforme à la revendication 2 ou 3, caractérisé par le fait que la surface que doit sensibiliser le matériau plastique fondu est humidifiée.

5. Procédé conforme à la revendication 1, caractérisé par le fait que l'adhérence entre le révélateur en poudre (toner) et la surface du substrat est obtenue par utilisation d'un solvant organique.

6. Procédé conforme à la revendication 1, caractérisé par le fait que l'adhérence entre la surface du substrat et les grains de poudre est obtenue par fusion locale au moins.

7. Procédé conforme aux revendications 1 ou 6, caractérisé par le fait que les grains de poudre contiennent un matériau absorbant les infrarouges.

8. Procédé conforme aux revendications 1 ou 6, caractérisé par le fait que le principal constituant du révélateur en poudre est un matériau ayant un grand angle de pertes à des fréquences de longueur d'onde micrométrique.